# FASCICULE DE BREVET EUROPEEN

(11) **EP 4 391 069 B1**
(45) Date de publication et mention de la délivrance du brevet: **11.06.2025**
(21) Numéro de dépôt: 23218847.4
(22) Date de dépôt: 20.12.2023
(51) Int. Cl.: H10B 63/00, H10D 30/47, H10D 30/67, H10D 30/69, H10D 62/10, H10D 62/13, H10D 62/80, H10D 64/01, H10D 64/62, H10D 99/00, H10B 51/20, H10B 53/20, H10B 53/30, H10B 51/30, B82Y 10/00, H10D 30/01, H10D 30/43, H10D 64/27

(54) **DISPOSITIF MÉMOIRE COMPRENANT D'IMPORTANTES SURFACES DE CONTACT ENTRE LE CANAL DE CONDUCTION ET LES RÉGIONS DE CONTACT**
SPEICHERANORDNUNG MIT GROSSEN KONTAKTFLÄCHEN ZWISCHEN LEITUNGSKANAL UND KONTAKTBEREICHEN
MEMORY DEVICE HAVING LARGE CONTACT AREAS BETWEEN THE CONDUCTION CHANNEL AND THE CONTACT REGIONS

(30) Priorité: 22.12.2022 FR 2214257
(43) Date de publication de la demande: 26.06.2024
(73) Titulaire: Commissariat à l'Energie Atomique et aux Energies Alternatives, 75015 Paris (FR)
(72) Inventeur: BARRAUD, Sylvain, 38054 Grenoble Cedex 09 (FR); COQUAND, Rémi, 38054 Grenoble Cedex 09 (FR); REBOH, Shay, 38054 Grenoble Cedex 09 (FR)
(74) Mandataire: Brevalex

(56) Documents cités:
- EP-A1- 4 092 750
- US-A1- 2017 092 541
- US-A1- 2021 408 227
- US-A1- 2022 199 783

## Description

### DOMAINE TECHNIQUE

L'invention concerne le domaine des dispositifs microélectroniques appliqués aux technologies CMOS avancées. L'invention porte notamment sur des dispositifs mémoires, par exemple de type 1T1R, 1T1C, 2T1R, 2T1C, de type OxRAM (« Oxide Random Access Memory » en anglais, ou mémoire résistive à base d'oxyde) ou FeRAM (« Ferroelectric Random Access Memory » en anglais, ou mémoire vive à couche ferroélectrique) ou CBRAM (« Conductive-Bridging Random Access Memory » en anglais, ou mémoire vive à pont conducteur), et la réalisation de tels dispositifs mémoires.

### État de la technique antérieure

La miniaturisation de l'électronique est en constante augmentation, mais l'industrie approche désormais de la limite d'échelle pour les matériaux classiques tels que le silicium. Dernièrement, les matériaux 2D sont apparus comme des candidats prometteurs pour une utilisation dans les dispositifs électroniques et optoélectroniques miniaturisés en raison de leurs propriétés uniques et de la très faible épaisseur des couches de ces matériaux qui peuvent être constitués d'une seule couche d'atomes ou de molécules.

Le document de K. P. O'Brien et al., "Advancing 2D Monolayer CMOS Through Contact, Channel and Interface Engineering," 2021 IEEE International Electron Devices Meeting (IEDM), 2021, pp. 7.1.1-7.1.4, propose de réaliser un transistor MOSFET en intégrant une couche de MoS₂ pour former le canal de conduction. Cette couche est connectée à deux régions de source et drain métalliques à base d'or, de palladium, de TiN, de tungstène ou encore de nickel. La grille arrière est formée par une couche de silicium dopé positionnée en face arrière sous une couche de diélectrique à base de SiO₂, HfO₂ ou d'Al₂O₃.

Afin de s'affranchir des contraintes liées au dépôt des matériaux métalliques des régions de contact (régions conductrices par lesquelles le canal de conduction du dispositif est accessible électriquement, et correspondant par exemple aux régions de source et de drain dans le cas d'un transistor) sur le matériau 2D, il est possible de former ces régions non pas sur la face supérieure de la couche de matériau 2D, mais contre les flancs de la couche de matériau 2D. Cette configuration, appelée « side contact », est toutefois problématique car la surface de contact entre la couche de matériau 2D et les régions de contact est faible, ce qui engendre d'importantes résistances de contact aux interfaces entre la couche de matériau 2D et les régions de contact.

Le document US 2022/045176 A1 décrit plusieurs procédés de réalisation de transistors FET de type « gate-last », dans lesquels des portions de silicium servent de support pour le dépôt d'une couche de matériau 2D. Outre les inconvénients liés au fait que les transistors réalisés ont des interfaces canal / source-drain de type « side contact », les portions de silicium utilisées pour déposer le matériau 2D forment une barrière de potentiel à l'interface avec le matériau 2D, ce qui n'est pas favorable car une partie du transport des charges peut s'effectuer dans ces portions de silicium et non dans le matériau 2D. Des autres dispositifs et procédés de l'art antérieur sont décrits par EP 4 092 750 A1, US 2021 / 0408227 A1, US 2022 / 0199783 A1 et US 2017 / 0092541 A1. Aucun de ces documents ne divulgue une couche de semi-conducteur ayant des deuxièmes zones s'étendant entre des régions de contact et des espaceurs diélectriques et ayant des premières zones formant des canaux des transistors à effet de champ, les premières et les deuxièmes zones formant une couche continue (revendication 1) ou étant sans discontinuité (revendication 9).

Ces problèmes se retrouvent également pour des dispositifs microélectroniques autres que des transistors FET, comme par exemple des dispositifs mémoires incluant un transistor.

### EXPOSÉ DE L'INVENTION

Un but de la présente invention est de proposer un dispositif mémoire dont la structure soit compatible avec tout type de matériau semi-conducteur dont les matériaux 2D, et ne présentant pas les inconvénients d'une configuration « side contact ».

Pour cela, la présente invention propose un dispositif mémoire comprenant au moins un empilement mémoire connecté électriquement en série avec un transistor de sélection, le dispositif mémoire comprenant un substrat sur lequel le transistor de sélection comprend :
- une couche de semi-conducteur comprenant plusieurs premières zones superposées les unes au-dessus des autres, les premières zones formant un canal de conduction électrique du transistor de sélection ;
- une grille de commande électrostatique et une couche de diélectrique de grille du transistor de sélection, des parties de la couche de diélectrique de grille étant chacune disposée entre une partie de la grille de commande électrostatique et l'une des premières zones de la couche de semi-conducteur ;
- des espaceurs diélectriques disposés contre des flancs de la grille de commande électrostatique ;
- des régions de contact couplées électriquement aux premières zones de la couche de semi-conducteur par des deuxièmes zones de la couche de semi-conducteur, les deuxièmes zones de la couche de semi-conducteur s'étendant entre les régions de contact et les espaceurs diélectriques, les régions de contact formant des régions de source / drain du transistor de sélection,

dans lequel l'une des régions de contact comprend l'empilement mémoire interposé entre une première portion conductrice, reliant électriquement l'empilement mémoire à la couche de semi-conducteur, et une deuxième portion conductrice formant un contact électrique de l'empilement mémoire ;
et dans lequel les deuxièmes zones de la couche de semi-conducteur ne sont pas disposées directement contre la grille de commande électrostatique et forment, avec les premières zones, une couche continue.

Le dispositif mémoire proposé se base sur une architecture ne comportant pas d'interface de type « side contact » entre le canal et les régions de contact grâce aux deuxièmes zones de la couche de semi-conducteur réalisant le couplage électrique entre le canal formé par les premières zones de la couche de semi-conducteur et les régions de contact. Ces deuxièmes zones de la couche de semi-conducteur, qui s'étendent contre au moins une partie des parois latérales, ou flancs, des régions de contact, forment une grande surface de contact avec les régions de contact, ce qui permet de réduire les résistances de contact de ces régions de contact. Ainsi, le courant électrique circulant dans le canal n'est pas réduit à cause de ces résistances de contact, ce qui ne réduit pas les performances du dispositif.

De plus, avec l'architecture proposée, la couche de semi-conducteur peut être réalisée après la grille de commande électrostatique et avant la réalisation des régions de contact. Ainsi, la couche de semi-conducteur dont les premières zones sont destinées à former le canal de conduction n'est pas détériorée par les étapes liées à la réalisation de la grille de commande électrostatique. Cela est particulièrement avantageux lorsque la couche de semi-conducteur comporte un matériau 2D.

En outre, la réalisation d'un tel dispositif ne nécessite pas de conserver des portions de silicium pour déposer la couche de semi-conducteur destinée à former le canal, supprimant ainsi le problème de barrière de potentiel à l'interface avec le matériau de la couche de semi-conducteur.

Le dispositif mémoire comporte une architecture de type « GAA stacked-nanosheet », ou à nanofeuilles empilées et grille totalement enrobante.

Dans le dispositif mémoire, l'une des régions de contact correspond à une électrode d'accès du dispositif mémoire, et l'autre région de contact comporte un empilement mémoire, c'est-à-dire un empilement de matériaux configuré pour réaliser une mémorisation d'information. Un tel empilement mémoire correspond par exemple à un empilement de type MIM (métal - isolant - métal).

Une ou plusieurs de ces régions de contact peuvent être communes à plusieurs dispositifs mémoires réalisés sur un même substrat.

La couche de semi-conducteur peut comporter un matériau bidimensionnel ou tout autre matériau semi-conducteur déposé par MOCVD (« Metal Organic Chemical Vapor Deposition » en anglais, ou dépôt chimique en phase vapeur aux organométalliques), CVD (« Chemical Vapor Deposition » en anglais, ou dépôt chimique en phase valeur) ou ALD (« Atomic Layer Deposition » en anglais, ou dépôt en couche atomique). Dans ce cas, le dispositif mémoire peut être réalisé avec de très faibles dimensions.

Le dispositif mémoire peut être tel que :
- chacune des régions de contact soit disposée dans une cavité comprenant des parois latérales formées au moins par les espaceurs diélectriques et par un matériau diélectrique d'isolation ;
- les deuxièmes zones de la couche de semi-conducteur recouvrent au moins une partie des parois des cavités dans lesquelles sont disposées les régions de contact.

Dans la configuration ci-dessus, les surfaces de contact des régions de contact avec la couche de semi-conducteur sont maximisées grâce à l'utilisation de la surface des parois des cavités, et avantageusement l'ensemble de la surface des parois de la cavité, pour former le contact entre les deuxièmes zones de la couche de semi-conducteur et les régions de contact, ce qui permet d'avoir de très faibles résistances de contact de ces régions, et donc un plus fort courant parcourant le canal de conduction du dispositif.

Le transistor de sélection peut être tel que chacune des premières zones de la couche de semi-conducteur peut être entourée par une même grille de commande électrostatique ou par une grille de commande électrostatique différente de celle entourant les autres premières zones de la couche de semi-conducteur.

Dans une première option de réalisation, le transistor de sélection peut comporter en outre une ou plusieurs portions diélectriques chacune entourée par l'une des premières zones de la couche de semi-conducteur et telles que chacune des portions diélectriques soit entourée par les premières zones de la couche de semi-conducteur. Ces portions diélectriques peuvent servir à combler un ou des espaces entre les premières zones de la couche de semi-conducteur.

Dans une seconde option de réalisation, chacune des premières zones de la couche de semi-conducteur n'entoure pas de portion diélectrique.

Le transistor de sélection peut comporter en outre des espaceurs diélectriques internes disposés contre des flancs d'une ou plusieurs parties de la grille de commande électrostatique. De tels espaceurs internes sont avantageux car ils permettent de réduire les capacités parasites au sein du dispositif.

L'empilement mémoire peut comporter une couche de matériau ferroélectrique ou une couche d'oxyde ou une couche ionique.

L'invention concerne également un composant microélectronique comportant plusieurs dispositifs mémoires tels que décrit précédemment, et dans lequel :
- les grilles de commande électrostatiques des transistors de sélection de de plusieurs des dispositifs mémoires sont communes et formées par les mêmes portions de matériau, et/ou
- l'une des régions de contact est commune à deux transistors de sélection de dispositifs mémoires voisins.

L'invention concerne également un procédé de réalisation d'au moins un dispositif mémoire comprenant au moins un empilement mémoire connecté électriquement en série avec un transistor de sélection, comprenant :
a) réalisation, sur un substrat, d'au moins un empilement alterné de portions d'un premier matériau et de portions d'un deuxième matériau, les premier et deuxième matériaux étant aptes à être gravés sélectivement l'un vis-à-vis de l'autre, puis
b) réalisation d'une grille temporaire recouvrant une partie d'une face supérieure et de faces latérales de l'empilement, puis
c) réalisation d'espaceurs diélectriques contre des flancs, ou parois latérales, de la grille temporaire, puis
d) gravure de parties de l'empilement non recouvertes par la grille temporaire et les espaceurs diélectriques, puis
e) gravure de la grille temporaire, puis
f) gravure des portions du premier matériau sélectivement vis-à-vis des portions du deuxième matériau, puis
g) réalisation d'au moins une partie d'une grille de commande électrostatique du transistor de sélection dans un espace formé par la gravure de la grille temporaire, telle que les espaceurs diélectriques soient disposés contre les flancs de la grille de commande électrostatique, puis
h) gravure des portions du deuxième matériau, puis
i) réalisation d'une couche de semi-conducteur, avantageusement un matériau 2D dont l'épaisseur peut être comprise entre 1 et 5 atomiques, comprenant plusieurs premières zones configurées pour former un canal de conduction électrique du transistor de sélection et disposées contre la grille dans des emplacements formés par la gravure des portions du deuxième matériau, la couche de semi-conducteur se prolongeant, sans discontinuité avec les premières zones, en formant des deuxièmes zones couvrant au moins une partie des flancs des espaceurs diélectriques et qui ne sont pas disposées directement contre la grille de commande électrostatique, puis
j) réalisation, sur le substrat, des régions de contact couplées électriquement aux premières zones de la couche de semi-conducteur par les deuxièmes zones de la couche de semi-conducteur, chaque deuxième zone de la couche de semi-conducteur s'étendant entre les régions de contact et les espaceurs diélectriques, les régions de contact formant des régions de source / drain du transistor de sélection, l'une des régions de contact comportant l'empilement mémoire interposé entre une première portion conductrice, reliant électriquement l'empilement mémoire à la couche de semi-conducteur, et une deuxième portion conductrice formant un contact électrique de l'empilement mémoire.

Le procédé peut comporter en outre, avant la mise en œuvre de l'étape c), un dépôt d'un matériau diélectrique d'isolation autour des espaceurs diélectriques, puis une gravure de cavités dans le matériau diélectrique d'isolation telle que chacune des cavités comprenne au moins une paroi latérale formée par l'un des espaceurs diélectriques, et :
- l'étape i) peut être mise en œuvre telle que les deuxièmes zones de la couche de semi-conducteur recouvrent au moins une partie des parois latérales des cavités, et
- l'étape j) peut être mise en œuvre telle que chacune des régions de contact soit disposée dans une des cavités.

Le procédé peut comporter en outre une étape de dépôt d'un diélectrique de grille du transistor de sélection mise en oeuvre :
- entre les étapes f) et g), dans l'espace formé par la gravure de la grille temporaire, la grille de commande électrostatique du transistor de sélection étant dans ce cas réalisée sur le diélectrique de grille, et/ou
- entre les étapes h) et i), dans les emplacements formés par la gravure des portions du deuxième matériau, la couche de semi-conducteur étant dans ce cas réalisée en recouvrant le diélectrique de grille.

Selon une première option de réalisation, l'étape i) peut être mise en œuvre telle que les premières zones de la couche de semi-conducteur recouvrent des parois des emplacements formés par la gravure des portions du deuxième matériau, et le procédé peut comporter en outre, entre les étapes i) et j), une réalisation de portions diélectriques dans des espaces restants des emplacements et telles que chacune des portions diélectriques soient entourées par les premières zones de la couche de semi-conducteur.

Selon une deuxième option de réalisation, l'étape i) peut être mise en œuvre telle que les premières zones de la couche de semi-conducteur remplissent les emplacements formés par la gravure des portions du deuxième matériau.

Le procédé peut comporter en outre, entre les étapes d) et e), une gravure de parties des portions du premier matériau disposées à l'aplomb des espaceurs diélectriques, et une réalisation d'espaceurs diélectriques internes à la place des parties gravées des portions du premier matériau.

Dans l'ensemble du document, les termes « sur » et « sous » sont utilisés sans distinction de l'orientation dans l'espace de l'élément auquel se rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments. Dans tout le document, le terme « couche » peut désigner une seule couche ou un empilement de plusieurs couches.

Dans l'ensemble du document, l'expression « coupler électriquement » est utilisée pour désigner une liaison électrique pouvant être directe ou pouvant être indirecte (c'est-à-dire réaliser à travers un ou plusieurs éléments électriques intermédiaires).

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
[Fig. 1]
[Fig. 2]
[Fig. 3]
[Fig. 4]
[Fig. 5]
[Fig. 6]
[Fig. 7]
[Fig. 8]
[Fig. 9]
[Fig. 10]
[Fig. 11]
[Fig. 12]
[Fig. 13]
[Fig. 14]
[Fig. 15], et
[Fig. 16] représentent schématiquement les étapes d'un procédé de réalisation d'un dispositif mémoire, objet de la présente invention, selon mode de réalisation particulier ;
[Fig. 17]
[Fig. 18]

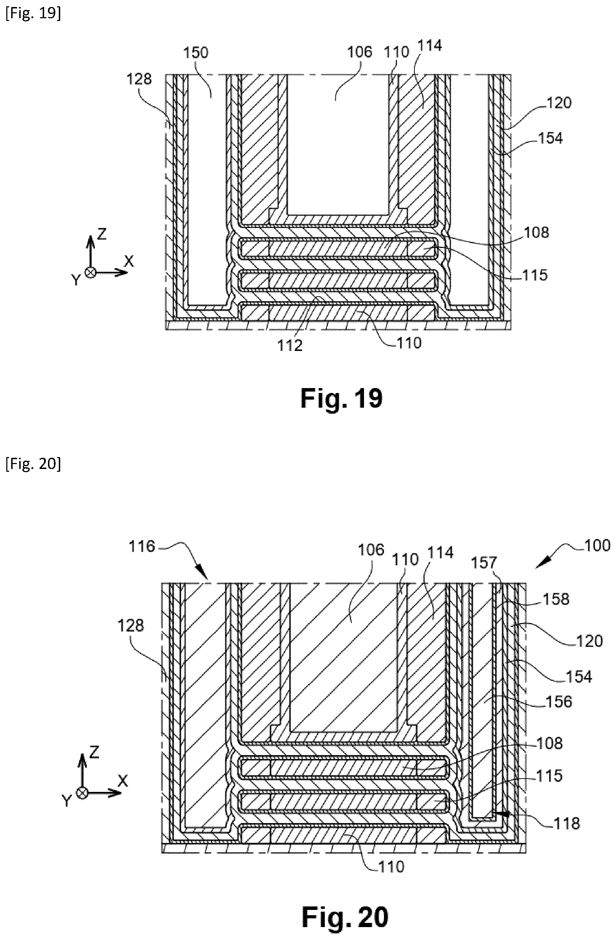

[Fig. 19], et
[Fig. 20] représentent schématiquement une partie des étapes d'un procédé de réalisation du dispositif mémoire, objet de la présente invention, selon une variante de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

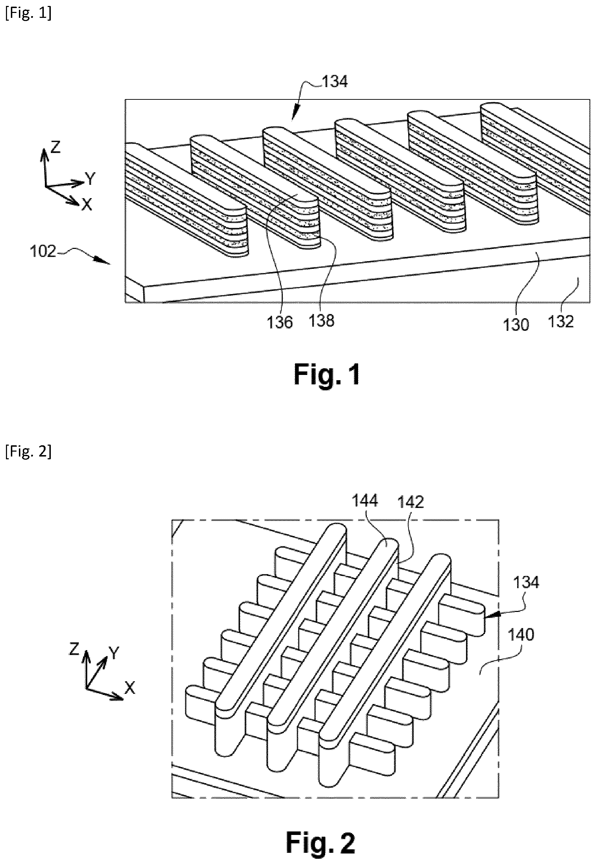

Un exemple de procédé de réalisation d'un dispositif mémoire 100 comprenant au moins un empilement mémoire 158 connecté électriquement en série à un transistor de sélection, selon un mode de réalisation particulier est décrit ci-dessous en lien avec les figures 1 à 16. Sur ces figures, la réalisation simultanée de plusieurs dispositifs mémoires 100 est représentée, ces dispositifs faisant partie d'un composant électronique 1000.

Un empilement alterné de couches comprenant un premier matériau et un deuxième matériau aptes à être gravés sélectivement l'un vis-à-vis de l'autre est tout d'abord réalisé sur un substrat 102. Selon un exemple avantageux, les premier et deuxième matériaux correspondent respectivement à du Si et du SiGe. D'autres couples de premier et deuxième matériaux sont également possibles : SiGe et Ge, Ge et GeSn, SiO₂ et silicium amorphe (a-Si). Plus généralement, il peut être envisagé d'utiliser, pour former cette alternance de couches des premier et deuxième matériaux, deux semi-conducteurs aptes à être gravés sélectivement l'un par rapport à l'autre, ou un matériau diélectrique et un semi-conducteur amorphe.

Le nombre de couches de cet empilement dépend du nombre de niveau de matériau semi-conducteur souhaité pour former le canal du dispositif 100. Dans l'exemple de réalisation décrit en lien avec les figures 1 à 16, l'empilement de couches comporte quatre couches de silicium empilées de manière alternée avec trois couches de SiGe. De manière avantageuse, le nombre de couches du premier matériau est compris entre 2 et 10, et le nombre de couches du deuxième matériau est compris entre 1 et 10.

A titre d'exemple, chacune des couches de l'empilement a une épaisseur comprise entre 5 nm et 25 nm, et par exemple égale à 12 nm.

Dans l'exemple de réalisation décrit en lien avec les figures 1 à 16, le substrat 102 correspond à un substrat SOI, c'est-à-dire comprenant une couche superficielle de silicium formant la première couche de l'empilement réalisé et qui est disposé sur une couche diélectrique enterrée 130 comprenant par exemple du SiO₂. La couche diélectrique enterrée 130 est disposée sur une couche support 132 comprenant par exemple du silicium. De manière alternative, le substrat 102 peut correspondre à un substrat de type autre que SOI, par exemple un substrat « bulk », ou substrat massif, de semi-conducteur (par exemple de silicium).

Une gravure de l'empilement de couches réalisé est ensuite mise en œuvre afin de former, sur le substrat 102 (sur la couche diélectrique enterrée 130 dans cet exemple), au moins un empilement 134 alterné de portions 136 du premier matériau et de portions 138 du deuxième matériau. Sur la figure 1, six empilements 134 distincts sont représentés, chacun comprenant quatre portions 136 et trois portions 138 empilées de manière alternée les unes sur les autres.

Chacun des empilements 134 a une forme sensiblement allongée, c'est-à-dire comporte une longueur (dimension selon l'axe X) supérieure à sa largeur (dimension selon l'axe Y). La largeur de chaque empilement 134 est par exemple comprise entre 20 nm et 200 nm, et la longueur de chaque empilement 134 est par exemple supérieure à 100 nm.

Une fine couche diélectrique 140, dont l'épaisseur est inférieure à 10 nm et par exemple égale à 7 nm ou 4 nm, est ensuite déposée de manière conforme sur l'ensemble de la structure, c'est-à-dire en couvrant les faces supérieures et les faces latérales des empilements 134 et les parties du substrat 102 (de la couche diélectrique enterrée 130 dans l'exemple de réalisation décrit) non recouvertes par les empilements 134. La couche diélectrique 140 comporte par exemple du SiO₂, pouvant être obtenu à partir de TEOS. Au moins une grille temporaire 142 est ensuite réalisée, couvrant une partie d'une face supérieure et des faces latérales des empilements 134.

Pour cela, un matériau adapté à la réalisation des grilles temporaires est déposé sur l'ensemble de la structure. De manière avantageuse, le matériau déposé est du silicium polycristallin. L'épaisseur de matériau déposé est supérieure à la somme des épaisseurs d'un des empilements 134 et de la couche diélectrique 140, par exemple égale à 380 nm. Une planarisation, par exemple une CMP (planarisation mécano-chimique), du matériau déposé est ensuite mise en œuvre afin qu'une épaisseur donnée, par exemple égale à 70 nm, soit conservée au-dessus des empilements 134. Un masque dur 144 est ensuite réalisé sur le matériau restant après la planarisation, le motif de ce masque dur définissant celui du ou des grilles temporaires 142 à réaliser. Par exemple, le masque dur 144 comporte une bicouche nitrure de semi-conducteur / oxyde de semi-conducteur tel que du SiN/SiO₂. Le matériau restant adapté à la réalisation des grilles temporaires est ensuite gravé conformément au motif défini par le masque dur 144, formant la ou les grilles temporaires 142. Dans l'exemple décrit, plusieurs grilles temporaires 142 sont réalisées (trois grilles temporaires 142 sont visibles sur la figure 2, chacune formée en couvrant les six empilements 134).

A titre d'exemple, la largeur (dimension selon l'axe X visible sur la figure 2) de chaque grille temporaire 142 est par exemple comprise entre 10 nm et plusieurs centaines de nm, et la longueur (dimension selon l'axe Y visible sur la figure 2) de chaque grille temporaire 142 dépend du nombre d'empilements 134 sur lesquels les grilles temporaire 142 doivent être réalisées, et par exemple égale à plusieurs dizaines de nm.

Des espaceurs diélectriques 114 sont ensuite réalisés contre des flancs des grilles temporaires 142. Pour cela, une couche de matériau adapté à la réalisation de ces espaceurs 114 est déposée de manière conforme sur l'ensemble de la structure, c'est-à-dire en recouvrant les faces supérieures et les faces latérales des empilements 134, des grilles temporaires 142 et des masques durs 144 et les parties du substrat 102 (de la couche diélectrique enterrée 130 dans l'exemple de réalisation décrit) non recouvertes par les empilements 134 et les grilles temporaires 142. Ce matériau adapté à la réalisation des espaceurs diélectriques 114 correspond par exemple à du SiN, du SiCO ou du SiBCN. L'épaisseur de cette couche est par exemple comprise entre 5 nm et 15 nm.

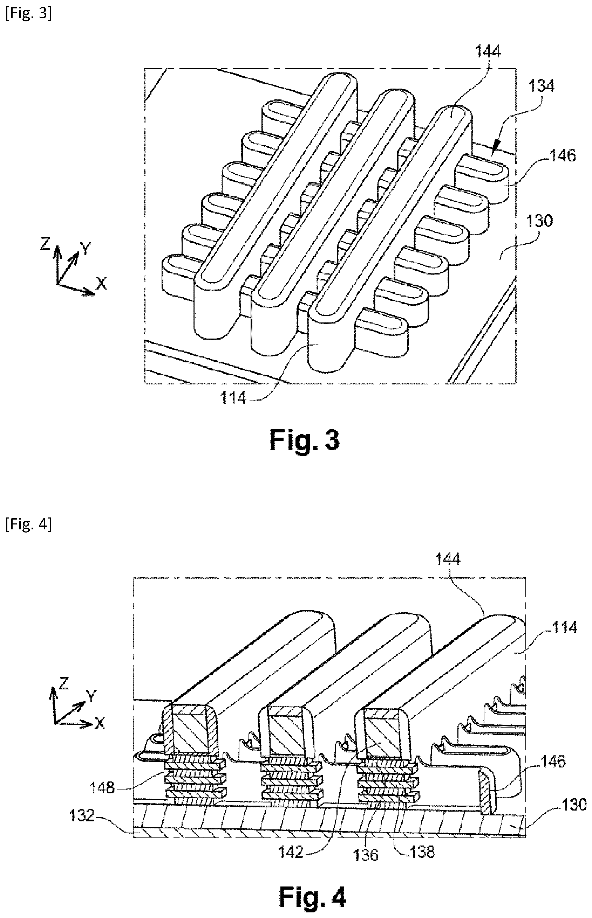

Une gravure anisotrope de cette couche est ensuite mise en œuvre telle que des portions restantes de cette couche disposées contre les flancs des grilles temporaires 142 forment les espaceurs diélectriques 114 (voir figure 3). Des portions restantes 146 de cette couche disposées contre les flancs des empilements 134 peuvent être conservées à l'issue de cette gravure, ou bien être avantageusement supprimées. La gravure anisotrope est mise en œuvre de manière à supprimer le matériau localisé sur les faces supérieures des grilles temporaires 142 et des empilements 134. En outre, cette gravure supprime également les parties de la couche 140 qui ne sont pas recouvertes par les grilles temporaires 142 et les espaceurs diélectriques 114.

Les parties des empilements 134 non recouvertes par les grilles temporaires 142, par les espaceurs diélectriques 114 ou par les portions restantes 146 sont gravées. Cette gravure est stoppée sur la couche diélectrique enterrée 130. Les parties restantes des portions 136 sont ensuite gravées partiellement et sélectivement vis-à-vis des parties restantes des portions 138, de manière à former, à l'aplomb des espaceurs diélectriques 114, des espaces 148 au-dessus et en dessous des extrémités des parties restantes des portions 138 (voir figure 4). La profondeur (dimension selon l'axe X sur la figure 4) gravée dans les parties restantes des portions 136 est par exemple comprise entre 5 nm et 15 nm.

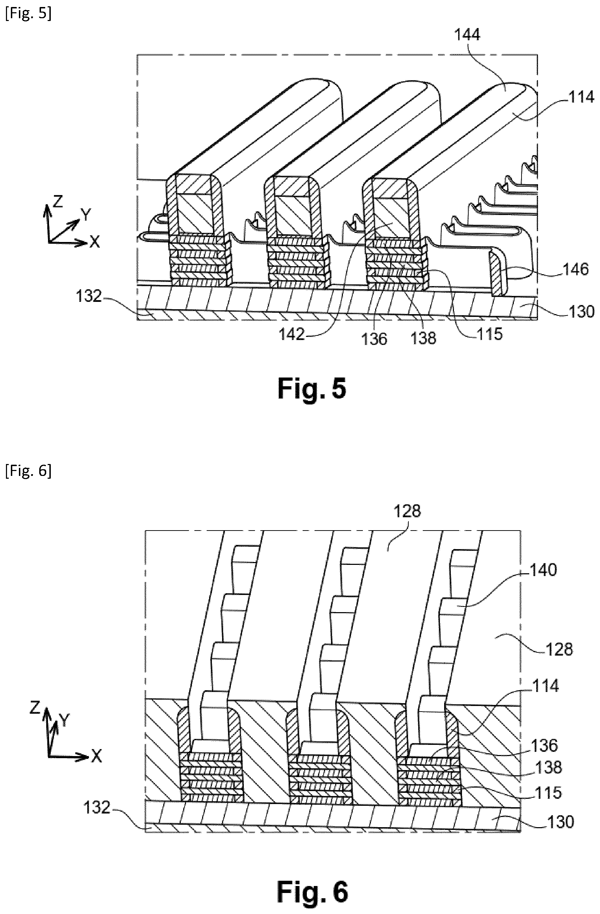

Les espaceurs diélectriques internes 115 sont ensuite réalisés dans les espaces 148 précédemment formés. Ces espaceurs diélectriques internes 115 sont obtenus en déposant un matériau diélectrique, par exemple du SiN, du SiBCN ou du SiCO de manière au moins à remplir les espaces 148. Le matériau déposé en dehors des espaces 148 est gravé de manière isotrope afin de ne conserver que les espaceurs diélectriques internes 115 (voir figure 5).

Un matériau diélectrique d'isolation 128, par exemple du SiO₂, est ensuite déposé autour des espaceurs diélectriques 114. Pour cela, le matériau diélectrique d'isolation 128 est déposé avec une forte épaisseur, puis une planarisation est mise en œuvre jusqu'à atteindre le masque dur 144. Le masque dur 144 est ensuite retiré par exemple par gravure humide, par exemple à l'aide d'une solution de H₃PO₄ diluée et utilisée à une température de 110°C. Les grilles temporaires 142 sont ensuite retirées, par exemple par gravure en utilisant une solution d'HF diluée à 0,5 % combinée à une solution de HCl diluée à 1 % et avec une solution de TMAH à 5 %. Cette gravure est stoppée lorsque les parties restantes de la couche diélectrique 140 sont atteintes (voir figure 6).

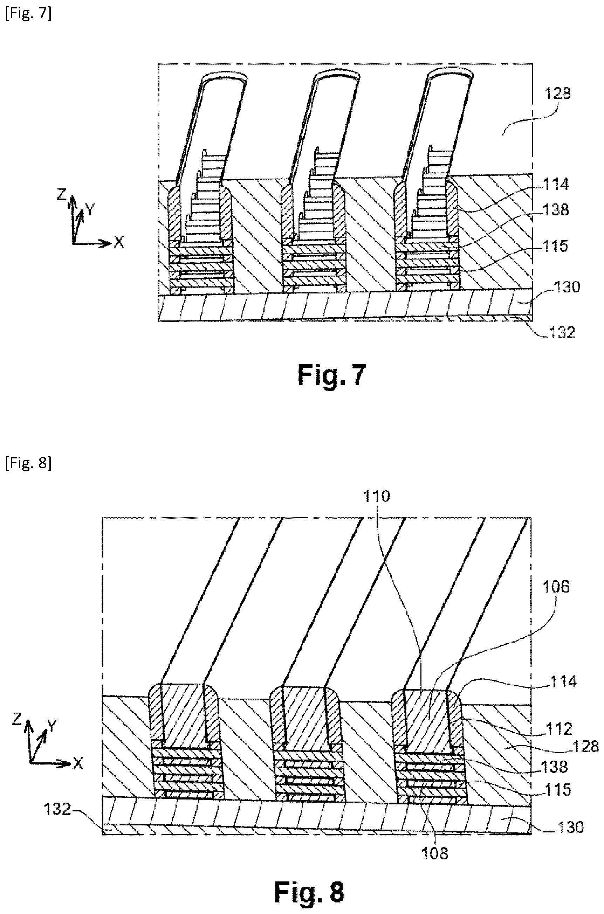

Les parties restantes de la couche diélectrique 140 sont ensuite gravées, puis les parties restantes des portions 136 sont gravées sélectivement vis-à-vis des parties restantes des portions 138, par exemple en mettant en œuvre une gravure humide. La structure obtenue à ce stade est représentée sur la figure 7.

Au moins une couche 112 destinée à former les diélectriques de grille des transistors de sélection des dispositifs mémoires 100 est ensuite déposée de manière conforme, notamment dans les espaces formés par la gravure des grilles temporaires 142 en recouvrant les parois formées par les espaceurs diélectriques 114 et les parties restantes des portions 138. Par exemple, cette couche comporte par exemple un matériau diélectrique high-K (à forte permittivité diélectrique) tel que du HfO₂. En variante, cette couche 112 destinée à former les diélectriques de grille peut comporter du SiO₂ ou de l'Al₂O₃ ou tout autre matériau ou combinaison de matériaux adaptés.

Des grilles de commande électrostatique 110 des transistors de sélection des dispositifs mémoires 100 sont réalisées par dépôt d'un ou plusieurs matériaux conducteurs sur la couche 112 destinée à former les diélectriques de grille des transistors de sélection, par un premier dépôt d'une fine couche de TiN (épaisseur par exemple égale à 3 nm) sur laquelle est empilée une couche de tungstène d'épaisseur par exemple égale à 200 nm. Dans l'exemple visible sur la figure 8, chacune des grilles 110 comporte une partie supérieure 106 et d'autres parties 108 entourant les parties restantes des portions 138. Il est en outre possible que les grilles 110 comportent un ou plusieurs matériaux différents du TiN et du W, comme par exemple du polysilicium dopé ou tout autre métal (Mo, etc.). Une planarisation avec arrêt sur le matériau diélectrique d'isolation 128 est mise en œuvre pour supprimer le ou les matériaux de la couche 112 destinée à former les diélectriques de grille et les grilles de commande électrostatique 110 déposés en dehors des espaces formés par la gravure des grilles temporaires 142.

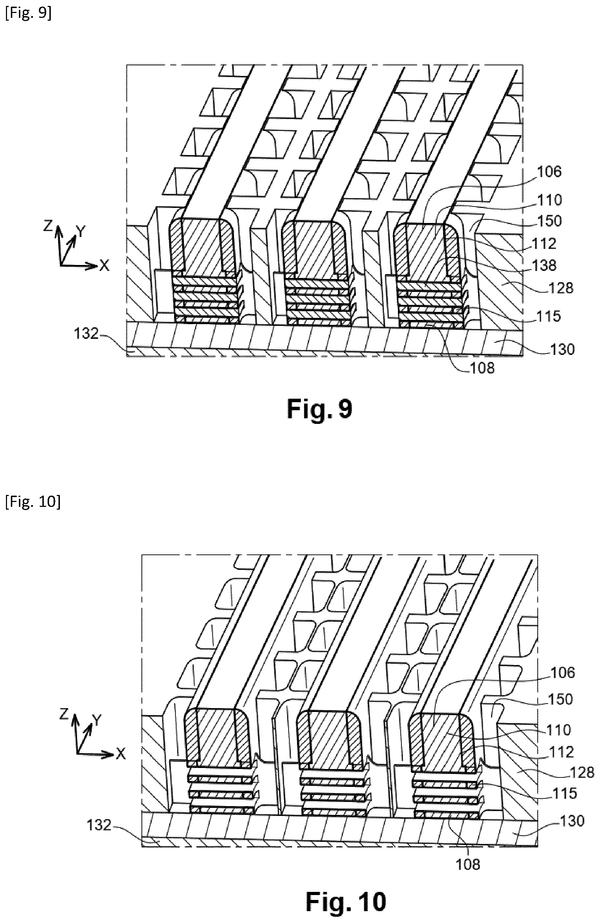

Une gravure d'une partie du matériau diélectrique d'isolation 128 est ensuite mise en œuvre de manière à former des cavités 150 comprenant des parois latérales formées par les espaceurs diélectriques 114, les espaceurs diélectriques internes 115 et, dans l'exemple décrit ici, des portions restantes du matériau diélectrique d'isolation 128 (voir figure 9). Ces cavités 150 forment des emplacements pour la réalisation des régions de contact des dispositifs 100.

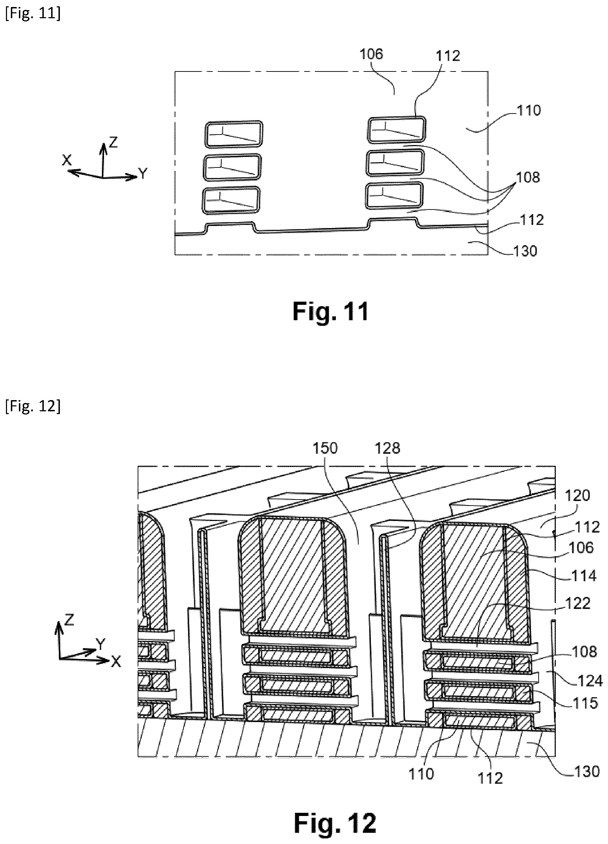

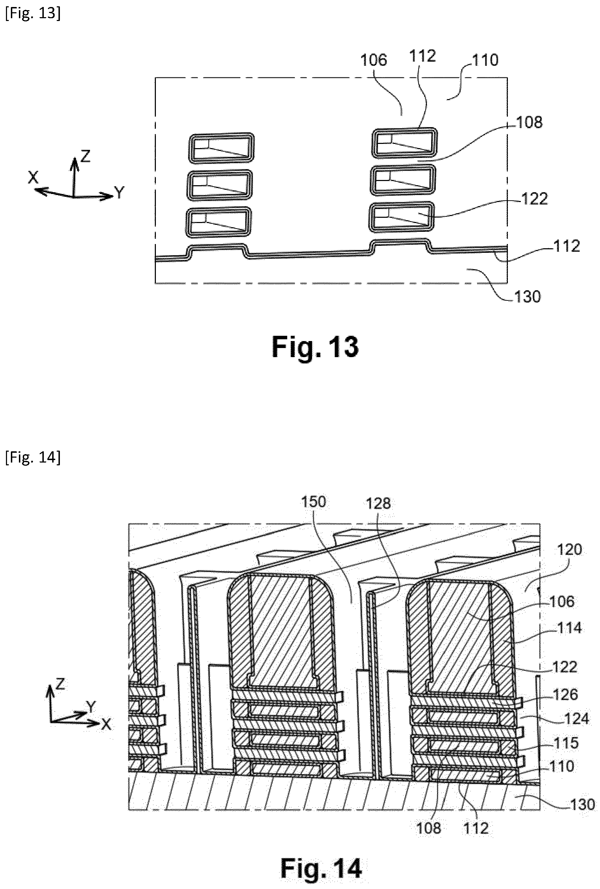

Les portions 138 sont ensuite gravées, par exemple par la mise en œuvre d'une gravure chimique utilisant une solution d'Hf-H₂O₂ (voir figures 10 et 11) lorsque les portions 138 comportent du SiGe. Comme cela est visible sur la figure 11 représentant une vue en coupe selon l'axe XX' représenté sur la figure 10, cette gravure forme des espaces en forme de tunnels dans lesquels les canaux des transistors sont destinés à être réalisés. Une couche de semi-conducteur 120 est ensuite déposée sur l'ensemble de la structure réalisée à ce stade du procédé (voir figures 12 et 13). Des premières zones 122 de cette couche de semi-conducteur 120 qui sont localisées dans les espaces en forme de tunnels précédemment formés sont destinées à former les canaux des transistors de sélection et sont disposées contre les diélectriques de grille. Des deuxièmes zones 124 de cette couche de semi-conducteur 120 qui recouvrent les parois (parois latérales et parois de fond dans l'exemple décrit ici) des cavités 150 sont destinées à être en contact avec les régions de contact qui seront ensuite réalisées. Le dépôt est réalisé sans discontinuité, ou sans interruption, entre les premières et deuxièmes zones 122 et 124.

De manière avantageuse, la couche de semi-conducteur 120 comporte au moins un matériau semi-conducteur 2D, par exemple un dichalcogénure de métaux de transition tel que du MoS₂, ou du WSe₂, ou du WS₂, ou du MoTe₂. Il est également possible que le matériau de la couche de semi-conducteur 120 corresponde à de l'IGZO, de l'In₂O₃, de l'IWO, de l'ITO, ou un oxyde de semi-conducteur amorphe, ou tout autre matériau semi-conducteur adapté.

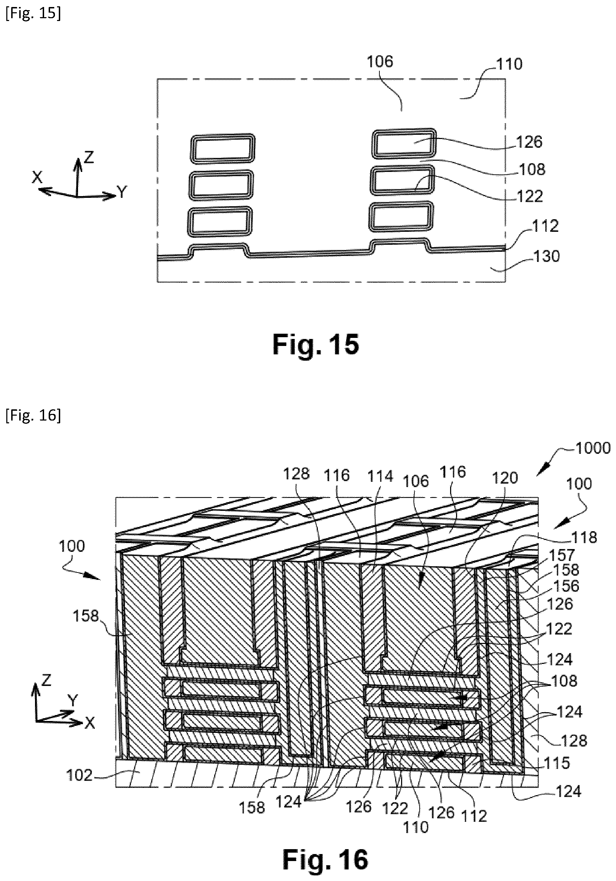

Une ou plusieurs couches diélectriques, comprenant par exemple de l'Al₂O₃ (ou du HfO₂) et/ou du SiO₂ (ou un diélectrique low-k, ou à faible permittivité diélectrique), sont ensuite déposées puis gravées de manière isotrope afin de ne conserver que des portions 126 localisées dans les espaces en forme de tunnels (voir figures 14 et 15). Ces portions 126 forment des barreaux diélectriques chacun entouré par l'une des premières zones 122 de la couche de semi-conducteur 120. Ains, la couche de semi-conducteur 120 comporte plusieurs premières zones 122 superposées les unes au-dessus des autres par l'intermédiaire d'une succession de barreaux 126 et de parties 108 de la grille 110 et de diélectriques de grille.

Enfin, des régions de contact 116, 118 sont réalisées en déposant, dans l'exemple décrit, un ou plusieurs matériaux métalliques dans les cavités 150 (voir figure 16). Avant ce ou ces dépôts métalliques, il est possible de déposer une couche de graphène dans les cavités 150, ce ou ces métaux étant ensuite déposés sur la couche de graphène. De manière avantageuse, les régions de contact 116, 118 comportent au moins un matériau métallique tel que de l'or, du palladium, du TiN, du W, du Ni, etc. Selon un exemple de réalisation, chacune des régions de contact 116, 118 comporte une couche de TiN sur laquelle est formée une portion de tungstène. Différents métaux peuvent être utilisés pour former les régions de contact 116, 118 afin de favoriser de faibles résistances de contact, comme par exemple : S, Bi, Sn, Pd, Ru, Cu, Ni, Ti, TiN, W, Au, etc. Ces matériaux peuvent aussi être modifiés ultérieurement (pour améliorer leur propriétés), par une étape de dopage par exemple. Ces régions de contact 116, 118 forment les régions de source / drain des transistors de sélection des dispositifs mémoires 100.

En outre, la région de contact 118 comporte un empilement mémoire 158, c'est-à-dire un empilement de matériaux dans lequel il est possible de réaliser une mémorisation d'information. Cet empilement mémoire 158 peut correspondre à un empilement de matériaux de type FeRAM incluant dans ce cas une couche de matériau ferroélectrique, ou OxRAM incluant dans ce une couche d'oxyde, ou CBRAM incluant dans ce cas une couche ionique, par exemple un empilement de type MIM (métal - isolant - métal).

Cet empilement mémoire 158 est disposé au sein du ou des matériaux métalliques formant le reste de la région de contact 118. Une partie du ou des matériaux métalliques est interposée entre l'empilement mémoire 158 et les parties de la couche de semi-conducteur 120 localisées dans la cavité 150 dans laquelle la région de contact 118 est réalisée. Ainsi, l'empilement mémoire 158 se retrouve interposé entre une première portion conductrice 157 de la région de contact 118, reliant électriquement l'empilement mémoire 158 à la couche de semi-conducteur 120, et une deuxième portion conductrice 156 de la région de contact 118 formant un contact électrique de l'empilement mémoire 158.

Ces régions de contact 116 et 118 se retrouvent couplées électriquement aux premières zones 122 de la couche de semi-conducteur 120 par l'intermédiaire des deuxièmes zones 124 de la couche de semi-conducteur 120 qui s'étendent entre les régions de contact 116, 118 et les espaceurs diélectriques 114 ainsi que contre les autres parois des régions de contact 116, 118 localisées dans les cavités 150. Le matériau de ces régions déposé en dehors des cavités 150 est supprimé par la mise en œuvre d'une planarisation avec arrêt sur le matériau diélectrique d'isolation 128.

Les dispositifs obtenus à l'issue de ce procédé correspondent aux dispositifs 100 représentés sur la figure 16.

Dans l'exemple de réalisation précédemment décrit, la couche de semi-conducteur 120 ne remplit pas complètement les espaces formés par la gravure des portions 138, et des portions diélectriques 126 sont réalisées dans les espaces restants après le dépôt de la couche de semi-conducteur 120.

Selon une première variante, il est possible de ne pas réaliser les portions diélectriques 126, la couche de semi-conducteur 120 remplissant dans ce cas, lors de son dépôt, les espaces restants formés par la gravure des portions 138. Dans ce cas, il est possible d'observer la formation d'air-gap, c'est-à-dire de creux ou d'espaces vides, dans les premières zones 122 de la couche de semi-conducteur 120. Néanmoins, ces air-gaps n'empêchent pas la continuité entre les premières zones 122 et les deuxièmes zones 124 de la couche de semi-conducteur 120.

Selon une autre variante (qui est compatible avec la première variante ci-dessus), il est possible que la couche 112 formant le diélectrique de grille du transistor de sélection du dispositif mémoire 100 ne soit pas déposée juste avant la réalisation de la grille 110 comme précédemment décrit, mais que cette couche soit déposée dans les espaces formés par la gravure des portions 138 et dans les cavités 1150, juste avant le dépôt de la couche de semi-conducteur 120. Dans ce cas, la couche 112 vient recouvrir les différentes parois sur lesquelles le matériau de la couche de semi-conducteur 120 est destiné à être déposé, homogénéisant ainsi les surfaces, et donc les interfaces, contre lesquelles la couche de semi-conducteur 120 est ensuite déposée.

Selon une autre variante (qui est compatible avec la première variante décrite ci-dessus), il est possible que la couche 112 soit déposée lors de deux étapes différentes : tout d'abord juste avant la réalisation de la grille 110 comme précédemment décrit en lien avec la figure 8, puis dans les espaces formés par la gravure des portions 138 et dans les cavités 150, juste avant le dépôt de la couche de semi-conducteur 120. Dans ce cas, les parties de la couche 112 localisées à l'aplomb de la grille 110 sont plus épaisses que les autres parties de la couche 112 car ces parties cumulent les épaisseurs de matériau déposées au cours des deux étapes de dépôt.

Dans l'exemple de réalisation précédemment décrit, toutes les parois latérales des cavités 150 sont recouvertes par les deuxièmes zones 124 de la couche de semi-conducteur 120. En variante, il est possible qu'une partie seulement de ces parois latérales soit recouverte par les deuxièmes zones 124.

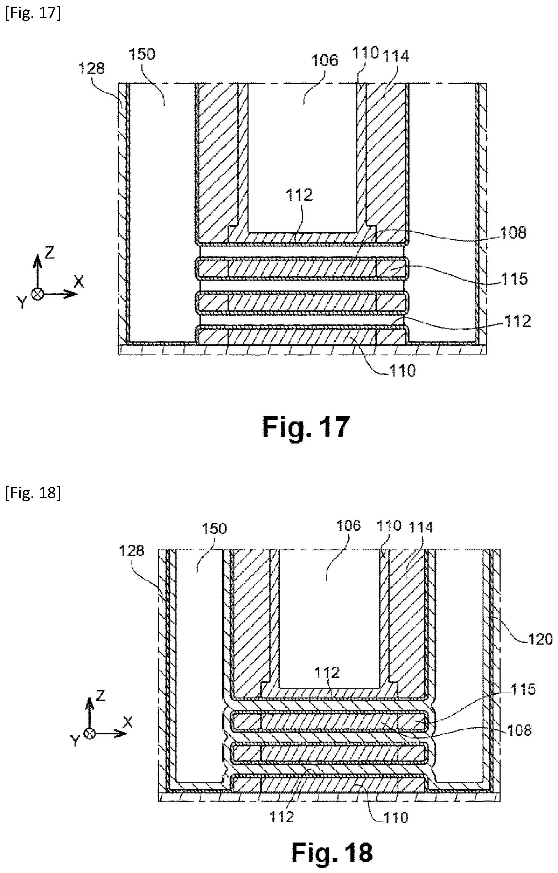

Les figures 17 à 20 représentent schématiquement une partie des étapes du procédé mis en œuvre combinant les deux variantes décrites ci-dessus.

Les étapes précédemment décrites en lien avec les figures 1 à 12 sont tout d'abord mises en œuvre.

Ensuite, contrairement au précédent exemple de réalisation dans lequel la couche de semi-conducteur 120 est déposée, la couche 112 formant les diélectriques de grille, comprenant avantageusement un matériau diélectrique high-K tel que du HfO₂, est déposée sur l'ensemble de la structure (voir figure 17). Des parties de cette couche 112 sont localisées dans les espaces en forme de tunnels précédemment formés, formant ainsi les diélectriques de grille, et d'autres parties de cette couche 112 recouvrent les parois des cavités 150.

La couche de semi-conducteur 120 est ensuite déposée sur l'ensemble de la structure, en recouvrant la couche 112 formant les diélectriques de grille (voir figure 18), de manière à remplir complètement les espaces restants en forme de tunnels. Les cavités 150 ne sont pas complètement remplies par le dépôt de la couche de semi-conducteur 120 et de la couche 112 formant les diélectriques de grille.

Les régions de contact 116, 118 sont ensuite réalisées, par exemple en réalisant un premier dépôt (par exemple ALD) de TiN (désigné par la référence 154 sur la figure 19), puis en remplissant le reste de l'espace disponible par du tungstène (désigné par la référence 156 sur la figure 20). Dans l'exemple décrit ici, ce dépôt de tungstène achève également la réalisation de la grille de commande 110. En outre, au cours du dépôt de tungstène, celui-ci est stoppé pour réaliser l'empilement mémoire 158 au sein de la région de contact 118, puis repris pour achever la réalisation des régions de contact 116, 118.

L'une des variantes ci-dessus peut être mise en œuvre sans que l'autre ne le soit. Par exemple, il est possible de déposer la couche 112 formant le diélectrique de grille dans les espaces formés par la gravure des portions 138, avant le dépôt de la couche de semi-conducteur 120, et que des espaces vides soient encore présents après le dépôt de la couche de semi-conducteur 120. Dans ce cas, les portions diélectriques 126 peuvent être réalisées comme précédemment décrit en lien avec les figures 14 et 15.

Dans l'exemple de réalisation représenté sur la figure 16, la grille de commande 110 est commune à plusieurs dispositifs 100, c'est-à-dire commande simultanément ces différents dispositifs, dont les régions de contact 116, 118 sont isolées électriquement de celles des autres dispositifs 100 voisins par les portions du matériau diélectrique d'isolation 128. En variante, il est possible que les grilles 110 réalisées ne soient pas communes aux différents dispositifs 100 réalisés.

En outre, chacune des premières zones 122 de la couche de semi-conducteur 120 peut être entourée par une même grille de commande électrostatique 110, comme c'est le cas dans les exemples précédemment décrits, ou par une grille de commande électrostatique différente de celle entourant les autres premières zones 122 de la couche de semi-conducteur 120.

Dans l'exemple de réalisation représenté sur la figure 16, chacune des régions de contact 116, 118 est disposée dans une cavité comprenant des parois latérales formées par les espaceurs diélectriques 114, 115 et par un matériau diélectrique d'isolation 128. Dans cette configuration, les deuxièmes zones 124 de la couche de semi-conducteur 120 recouvrent les parois latérales et les parois de fond des cavités dans lesquelles sont disposées les régions de contact 116, 118.

En alternative, il est possible que des régions de contact soient communes à plusieurs dispositifs 100. Par exemple, il est possible que pour deux dispositifs 100 adjacents, le matériau diélectrique d'isolation 128 ne soit pas présent afin qu'une même région de contact, par exemple la région de contact 118 incluant l'empilement mémoire 158, soit couplée électriquement aux canaux de ces deux dispositifs 100 voisins. Une telle configuration permet par exemple la réalisation de dispositifs mémoires de type 2T1R ou 2T1C.

## Revendications

1. Dispositif mémoire (100) comprenant au moins un empilement mémoire (158) connecté électriquement en série avec un transistor de sélection, le dispositif mémoire (100) comprenant un substrat (102) sur lequel le transistor de sélection comprend :
- une couche de semi-conducteur (120) comprenant plusieurs premières zones (122) superposées les unes au-dessus des autres, les premières zones (122) formant un canal de conduction électrique du transistor de sélection ;
- une grille de commande électrostatique (110) et une couche (112) de diélectrique de grille du transistor de sélection, des parties de la couche (112) de diélectrique de grille étant chacune disposée entre une partie (106, 108) de la grille de commande électrostatique (110) et l'une des premières zones (122) de la couche de semi-conducteur (120) ;
- des espaceurs diélectriques (114) disposés contre des flancs de la grille de commande électrostatique (110) ;
- des régions de contact (116, 118) couplées électriquement aux premières zones (122) de la couche de semi-conducteur (120) par des deuxièmes zones (124) de la couche de semi-conducteur (120), les deuxièmes zones (124) de la couche de semi-conducteur (120) s'étendant entre les régions de contact (116, 118) et les espaceurs diélectriques (114), les régions de contact (116, 118) formant des régions de source / drain du transistor de sélection,
dans lequel l'une des régions de contact (118) comprend l'empilement mémoire (158) interposé entre une première portion conductrice (157), reliant électriquement l'empilement mémoire (158) à la couche de semi-conducteur (120), et une deuxième portion conductrice (156) formant un contact électrique de l'empilement mémoire (158) ;
et dans lequel les deuxièmes zones (124) de la couche de semi-conducteur (120) ne sont pas disposées directement contre la grille de commande électrostatique (110) et forment, avec les premières zones (122), une couche continue.

2. Dispositif mémoire (100) selon la revendication 1, dans lequel la couche de semi-conducteur (120) comporte un matériau bidimensionnel ou tout autre matériau semi-conducteur déposé par MOCVD, CVD ou ALD.

3. Dispositif mémoire (100) selon l'une des revendications précédentes, dans lequel :
- chacune des régions de contact (116, 118) est disposée dans une cavité (150) comprenant des parois latérales formées au moins par les espaceurs diélectriques (114) et par un matériau diélectrique d'isolation (128) ;
- les deuxièmes zones (124) de la couche de semi-conducteur (120) recouvrent au moins une partie des parois des cavités (150) dans lesquelles sont disposées les régions de contact (116, 118).

4. Dispositif mémoire (100) selon l'une des revendications précédentes, dans lequel le transistor de sélection est tel que chacune des premières zones (122) de la couche de semi-conducteur (120) est entourée par une même grille de commande électrostatique (110) ou par une grille de commande électrostatique (110) différente de celle entourant les autres premières zones (122) de la couche de semi-conducteur (120).

5. Dispositif mémoire (100) selon l'une des revendications précédentes, dans lequel le transistor de sélection comporte en outre une ou plusieurs portions diélectriques (126) chacune disposée entre deux premières zones (122) de la couche de semi-conducteur (120) et telles que chacune des portions diélectriques (126) soit entourée par les premières zones (122) de la couche de semi-conducteur (120).

6. Dispositif mémoire (100) selon l'une des revendications précédentes, dans lequel le transistor de sélection comporte en outre des espaceurs diélectriques internes (115) disposés contre des flancs d'une ou plusieurs parties (108) de la grille de commande électrostatique (110).

7. Dispositif mémoire (100) selon l'une des revendications précédentes, dans lequel l'empilement mémoire (158) comporte une couche de matériau ferroélectrique ou une couche d'oxyde ou une couche ionique.

8. Composant microélectronique (1000) comportant plusieurs dispositifs mémoires (100) selon l'une des revendications précédentes, et dans lequel :
- les grilles de commande électrostatiques (110) des transistors de sélection de plusieurs des dispositifs mémoires (100) sont communes et formées par les mêmes portions de matériau, et/ou
- l'une des régions de contact (116, 118) est commune à deux transistors de sélection de dispositifs mémoires (100) voisins.

9. Procédé de réalisation d'un dispositif mémoire (100) comprenant au moins un empilement mémoire (158) connecté électriquement en série avec un transistor de sélection, comprenant :
a) réalisation, sur un substrat (102), d'au moins un empilement (134) alterné de portions d'un premier matériau (136) et de portions d'un deuxième matériau (138), les premier et deuxième matériaux étant aptes à être gravés sélectivement l'un vis-à-vis de l'autre, puis
b) réalisation d'une grille temporaire (142) recouvrant une partie d'une face supérieure et de faces latérales de l'empilement (134), puis
c) réalisation d'espaceurs diélectriques (114) contre des flancs de la grille temporaire (142), puis
d) gravure de parties de l'empilement (134) non recouvertes par la grille temporaire (142) et les espaceurs diélectriques (114), puis
e) gravure de la grille temporaire (142), puis
f) gravure des portions du premier matériau (136) sélectivement vis-à-vis des portions du deuxième matériau (138), puis
g) réalisation d'au moins une partie d'une grille de commande électrostatique (110) du transistor de sélection dans un espace formé par la gravure de la grille temporaire (142), telle que les espaceurs diélectriques (114) soient disposés contre les flancs de la grille de commande électrostatique (110), puis
h) gravure des portions du deuxième matériau (138), puis
i) réalisation d'une couche de semi-conducteur (120) comprenant plusieurs premières zones (122) configurées pour former un canal de conduction électrique du transistor de sélection et disposées contre la grille (110) dans des emplacements formés par la gravure des portions du deuxième matériau (138), la couche de semi-conducteur (120) se prolongeant, sans discontinuité avec les premières zones (122), en formant des deuxièmes zones (124) couvrant au moins une partie des flancs des espaceurs diélectriques (114) et qui ne sont pas disposées directement contre la grille de commande électrostatique (110), puis
j) réalisation, sur le substrat (102), des régions de contact (116, 118) couplées électriquement aux premières zones (122) de la couche de semi-conducteur (120) par les deuxièmes zones (124) de la couche de semi-conducteur (120), chaque deuxième zone (124) de la couche de semi-conducteur (120) s'étendant entre les régions de contact (116, 118) et les espaceurs diélectriques (114), les régions de contact (116, 118) formant des régions de source / drain du transistor de sélection, l'une des régions de contact (118) comportant l'empilement mémoire (158) interposé entre une première portion conductrice (157), reliant électriquement l'empilement mémoire (158) à la couche de semi-conducteur (120), et une deuxième portion conductrice (156) formant un contact électrique de l'empilement mémoire (158), dans lequel le procédé comporte en outre la réalisation d'une couche de diélectrique de grille du transistor de sélection telle que des parties de la couche de diélectrique de grille sont chacune disposées entre une partie de la grille de commande électrostatique et l'une des premières zones de la couche de semi-conducteur.

10. Procédé selon la revendication 9, comportant en outre, entre les étapes d) et e), un dépôt d'un matériau diélectrique d'isolation (128) autour des espaceurs diélectriques (114), puis une gravure de cavités (150) dans le matériau diélectrique d'isolation (128) telle que chacune des cavités (150) comprenne au moins une paroi latérale formée par l'un des espaceurs diélectriques (114), et dans lequel :
- l'étape i) est mise en œuvre telle que les deuxièmes zones (124) de la couche de semi-conducteur (120) recouvrent au moins une partie des parois latérales des cavités (150), et
- l'étape j) est mise en œuvre telle que chacune des régions de contact (116, 118) soit disposée dans une des cavités (150).

11. Procédé selon l'une des revendications 9 ou 10, comportant une étape de dépôt de la couche (112) de diélectrique de grille du transistor de sélection mise en œuvre :
- entre les étapes f) et g), dans l'espace formé par la gravure de la grille temporaire (142), la grille de commande électrostatique (110) du transistor de sélection étant dans ce cas réalisée sur la couche (112) de diélectrique de grille, et/ou
- entre les étapes h) et i), dans les emplacements formés par la gravure des portions du deuxième matériau (138), la couche de semi-conducteur (120) étant réalisée ensuite en recouvrant la couche (112) de diélectrique de grille.

12. Procédé selon l'une des revendications 9 à 11, dans lequel l'étape i) est mise en œuvre telle que les premières zones (122) de la couche de semi-conducteur (120) recouvrent des parois des emplacements formés par la gravure des portions du deuxième matériau (138), et le procédé comporte en outre, entre les étapes i) et j), une réalisation de portions diélectriques (126) dans des espaces restants des emplacements et telles que chacune des portions diélectriques (126) soient entourées par les premières zones (122) de la couche de semi-conducteur (120).

13. Procédé selon l'une des revendications 9 à 11, dans lequel l'étape i) est mise en œuvre telle que les premières zones (122) de la couche de semi-conducteur (120) remplissent les emplacements formés par la gravure des portions du deuxième matériau (138).

14. Procédé selon l'une des revendications 9 à 13, comportant en outre, entre les étapes d) et e), une gravure de parties des portions du premier matériau (136) disposées à l'aplomb des espaceurs diélectriques (114), et une réalisation d'espaceurs diélectriques internes (115) à la place des parties gravées des portions du premier matériau (136).

## Patentansprüche

1. Speichervorrichtung (100) umfassend mindestens einen Speicherstapel (158), der elektrisch in Reihe mit einem Auswahltransistor verbunden ist, wobei die Speichervorrichtung (100) ein Substrat (102) umfasst, an dem der Auswahltransistor Folgendes umfasst:
- eine Halbleiterschicht (120), umfassend mehrere erste Bereiche (122), die übereinander angeordnet sind, wobei die ersten Bereiche (122) einen elektrisch leitenden Kanal des Auswahltransistors bilden;
- ein elektrostatisches Steuergitter (110) und eine Gitterdielektrizitätsschicht (112) des Auswahltransistors, wobei die Teile der Gitterdielektrizitätsschicht (112) jeweils zwischen einem Teil (106, 108) des elektrostatischen Steuergitters (110) und einem der ersten Bereiche (122) der Halbleiterschicht (120) angeordnet sind;
- dielektrische Abstandshalter (114), die an Flanken des elektrostatischen Steuergitters (110) angeordnet sind;
- Kontaktbereiche (116, 118), die über zweite Bereiche (124) der Halbleiterschicht (120) elektrisch mit den ersten Bereichen (122) der Halbleiterschicht (120) gekoppelt sind, wobei sich die zweiten Bereiche (124) der Halbleiterschicht (120) zwischen den Kontaktbereichen (116, 118) und den dielektrischen Abstandshaltern (114) erstrecken, wobei die Kontaktbereiche (116, 118) Source-/Drain-Bereiche des Auswahltransistors bilden,
wobei einer der Kontaktbereiche (118) den Speicherstapel (158) umfasst, der zwischen einem ersten leitenden Abschnitt (157) eingelegt ist, der den Speicherstapel (158) mit der Halbleiterschicht (120) elektrisch verbindet, und einem zweiten leitenden Abschnitt (156), der einen elektrischen Kontakt des Speicherstapels (158) bildet; und wobei die zweiten Bereiche (124) der Halbleiterschicht (120) nicht direkt gegen das elektrostatische Steuergitter (110) angeordnet sind und zusammen mit den ersten Bereichen (122) eine durchgehende Schicht bilden.

2. Speichervorrichtung (100) nach Anspruch 1, wobei die Halbleiterschicht (120) ein zweidimensionales oder ein anderes durch MOCVD, CVD oder ALD hinterlegtes Halbleitermaterial aufweist.

3. Speichervorrichtung (100) nach einem der vorstehenden Ansprüche, wobei:
- jeder der Kontaktbereiche (116, 118) in einem Hohlraum (150) angeordnet ist, der Seitenwände umfasst, die mindestens durch die dielektrischen Abstandshalter (114) und durch ein dielektrisches Isolationsmaterial (128) gebildet sind;
- die zweiten Bereiche (124) der Halbleiterschicht (120) mindestens einen Teil der Wände der Hohlräume (150) bedecken, in denen die Kontaktbereiche (116, 118) angeordnet sind.

4. Speichervorrichtung (100) nach einem der vorstehenden Ansprüche, wobei jeder der ersten Bereiche (122) der Halbleiterschicht (120) von demselben elektrostatischen Steuergitter (110) oder von einem elektrostatischen Steuergitter (110) umgeben ist, das sich von dem unterscheidet, welches die anderen ersten Bereiche (122) der Halbleiterschicht (120) umgibt.

5. Speichervorrichtung (100) nach einem der vorstehenden Ansprüche, die weiter einen oder mehrere dielektrische Abschnitte (126) aufweist, die jeweils zwischen zwei ersten Bereichen (122) der Halbleiterschicht (120) und derart angeordnet sind, dass jeder der dielektrischen Abschnitte (126) von einem der ersten Bereiche (122) der Halbleiterschicht (120) umgeben ist.

6. Speichervorrichtung (100) nach einem der vorstehenden Ansprüche, die weiter innere dielektrische Abstandshalter (115) aufweist, die an Flanken eines oder mehrerer Teile (108) des elektrostatischen Steuergitters (110) angeordnet sind.

7. Speichervorrichtung (100) nach einem der vorhergehenden Ansprüche, wobei der Speicherstapel (158) eine Schicht aus ferroelektrischem Material oder eine Oxid- oder lonenschicht aufweist.

8. Mikroelektronische Komponente (1000), aufweisend mehrere mikroelektronische Vorrichtungen (100) nach einem der vorstehenden Ansprüche, und wobei:
- die elektrostatischen Steuergitter (110) der Auswahltransistoren mehrerer Speichervorrichtungen (100) gemein sind und einstückig von denselben Materialabschnitten gebildet werden, und/oder
- einer der Kontaktbereiche (116, 118) zwei benachbarten Auswahltransistoren von Speichervorrichtungen (100) gemein ist.

9. Verfahren zum Herstellen einer Speichervorrichtung (100) umfassend mindestens einen Speicherstapel (158), der elektrisch in Reihe mit einem Auswahltransistor verbunden ist, umfassend:
a) Herstellen, auf einem Substrat (102), mindestens eines abwechselnden Stapels (134) aus Abschnitten eines ersten Materials (136) und Abschnitten eines zweiten Materials (138), wobei das erste und das zweite Material selektiv in Bezug zueinander geätzt werden können, anschließend
b) Herstellen eines temporären Gitters (142), das einen Teil einer oberen Fläche und von Seitenflächen des Stapels (134) bedeckt, anschließend
c) Herstellen von dielektrischen Abstandshaltern (114) an Flanken des temporären Gitters (142), anschließend
d) Ätzen von Teilen des Stapels (134), die nicht von dem temporären Gitter (142) und den dielektrischen Abstandshaltern (114) bedeckt sind, anschließend
e) Ätzen des temporären Gitters (142), anschließend
f) selektives Ätzen der Abschnitte des ersten Materials (136) in Bezug auf die Abschnitte des zweiten Materials (138), anschließend
g) Herstellen mindestens eines Teils eines elektrostatischen Steuergitters (110) in einem Raum, der durch das Ätzen des temporären Gitters (142) gebildet wurde, derart, dass die dielektrischen Abstandshalter (114) an den Flanken des elektrostatischen Steuergitter (110) angeordnet sind, anschließend
h) Ätzen der Abschnitte des zweiten Materials (138), anschließend
i) Herstellen einer Halbleiterschicht (120) mit mehreren ersten Bereichen (122), die so eingerichtet sind, dass sie einen elektrisch leitenden Kanal des Auswahltransistors bilden, und die gegen das Gitter (110) an Stellen angeordnet sind, die durch das Ätzen von Abschnitten des zweiten Materials (138) gebildet werden, wobei sich die Halbleiterschicht (120) ohne Unterbrechung zu den ersten Bereichen (122) fortsetzt, indem sie zweite Bereiche (124) bildet, die zumindest einen Teil der Flanken der dielektrischen Abstandshalter (114) bedecken und die nicht direkt gegen das elektrostatische Steuergitter (110) angeordnet sind, und anschließend
j) Herstellen, auf dem Substrat (102), von Kontaktbereichen (116, 118), die elektrisch mit den ersten Bereichen (122) der Halbleiterschicht (120) durch die zweiten Bereiche (124) der Halbleiterschicht (120) gekoppelt sind, wobei jeder zweite Bereich (124) der Halbleiterschicht (120) sich zwischen den Kontaktbereichen (116, 118) und den dielektrischen Abstandshaltern (114) erstreckt, wobei die Kontaktbereiche (116, 118) Source-/Drain-Bereiche des Auswahltransistors bilden, wobei einer der Kontaktbereiche (118) den Speicherstapel (158) aufweist, der zwischen einen ersten leitenden Abschnitt (157) eingelegt ist, der den Speicherstapel (158) mit der Halbleiterschicht (120) elektrisch verbindet, und einen zweiten leitenden Abschnitt (156), der einen elektrischen Kontakt des Speicherstapels (158) bildet, wobei das Verfahren ferner das Herstellen einer Gitterdielektrizitätsschicht des Auswahltransistors aufweist, so dass Teile der Gitterdielektrizitätsschicht jeweils zwischen einem Teil des elektrostatischen Steuergitters und einem der ersten Bereiche der Halbleiterschicht angeordnet sind.

10. Verfahren nach Anspruch 9, umfassend unter anderem, zwischen den Schritten d) und e), ein Abscheiden eines dielektrischen Isolationsmaterials (128) um die dielektrischen Abstandshalter (114) herum, und anschließend ein Ätzen von Hohlräumen (150) in dem dielektrischen Isolationsmaterial (128) derart, dass jeder der Hohlräume (150) mindestens eine Seitenwand umfasst, die von einem der dielektrischen Abstandshalter (114) gebildet wird, und wobei:
- Schritt i) so ausgeführt ist, dass die zweiten Bereiche (124) der Halbleiterschicht (120) mindestens einen Teil der Seitenwände der Hohlräume (150) bedecken, und
- Schritt j) so ausgeführt ist, dass jeder der Kontaktbereiche (116, 118) in einem der Hohlräume (150) angeordnet ist.

11. Verfahren nach einem der Ansprüche 9 oder 10, umfassend einen Schritt der Ablagerung der Gitterdielektrizitätsschicht (112) des ausgeführten Auswahltransistors:
- zwischen den Schritten f) und g), in dem durch die Gravur des temporären Gitters (142) gebildeten Raum, wobei das elektrostatische Steuergitter (110) des Auswahltransistors in diesem Fall auf der Gitterdielektrizitätsschicht (112) ausgeführt ist, und/oder
- zwischen den Schritten h) und i), in den durch das Ätzen der Abschnitte des zweiten Materials (138) gebildeten Stellen, wobei die Halbleiterschicht (120) anschließend hergestellt wird, indem die Gitterdielektrizitätsschicht (112) bedeckt wird.

12. Verfahren nach einem der Ansprüche 9 bis 11, wobei Schritt i) derart ausgeführt wird, dass die ersten Bereiche (122) der Halbleiterschicht (120) Wände der Stellen, die durch das Ätzen der Abschnitte des zweiten Materials (138) gebildet wurden, bedecken, und das Verfahren zwischen den Schritten i) und j) weiter ein Herstellen von dielektrischen Abschnitten (126) in verbleibenden Räumen der Stellen und derart umfasst, dass jeder der dielektrischen Abschnitte (126) von den ersten Bereichen (122) der Halbleiterschicht (120) umgeben ist.

13. Verfahren nach einem der Ansprüche 9 bis 11, wobei Schritt i) derart ausgeführt wird, dass die ersten Bereiche (122) der Halbleiterschicht (120) die Stellen, die durch das Ätzen der Abschnitte des zweiten Materials (138) gebildet wurden, vollständig füllen.

14. Verfahren nach einem der Ansprüche 9 bis 13, umfassend zwischen den Schritten d) und e) weiter ein Ätzen von Teilen der Abschnitte des ersten Materials (136), die senkrecht zu den dielektrischen Abstandshaltern (114) angeordnet sind, und ein Herstellen von inneren dielektrischen Abstandshaltern (115) anstelle der geätzten Teile der Abschnitte des ersten Materials (136).

## Claims

1. A memory device (100) comprising at least one memory stack (158) electrically connected in series with a selection transistor, the memory device (100) comprising a substrate (102) over which the selection transistor comprises:
- a semiconductor layer (120) comprising several first areas (122) superimposed on top of one another, the first areas (122) forming an electrical conduction channel of the selection transistor;
- an electrostatic control gate (110) and a gate dielectric layer (112) of the selection transistor, parts of the gate dielectric layer (112) being each arranged between a part (106, 108) of the electrostatic control gate (110) and one of the first areas (122) of the semiconductor layer (120);
- dielectric spacers (114) arranged against sidewalls of the electrostatic control gate (110);
- contact regions (116, 118) electrically coupled to the first areas (122) of the semiconductor layer (120) via second areas (124) of the semiconductor layer (120), the second areas (124) of the semiconductor layer (120) extending between the contact regions (116, 118) and the dielectric spacers (114), the contact regions (116, 118) forming source/drain regions of the selection transistor.
wherein one of the contact regions (118) comprises the memory stack (158) interposed between a first conductive portion (157), electrically connecting the memory stack (158) to the semiconductor layer (120), and a second conductive portion (156) forming an electrical contact of the memory stack (158);
and wherein the second areas (124) of the semiconductor layer (120) are not arranged directly against the electrostatic control gate (110) and form a continuous layer with the first areas (122).

2. The memory device (100) according to claim 1, wherein the semiconductor layer (120) includes a two-dimensional material or any other semiconductor material deposited by MOCVD, CVD or ALD.

3. The memory device (100) according to any of the preceding claims, wherein:
- each of the contact regions (116, 118) is arranged in a cavity (150) comprising lateral walls formed at least by the dielectric spacers (114) and by an insulating dielectric material (128);
- the second areas (124) of the semiconductor layer (120) cover at least part of the walls of the cavities (150) in which the contact regions (116, 118) are arranged.

4. The memory device (100) according to any of the preceding claims, wherein the selection transistor is such that each of the first areas (122) of the semiconductor layer (120) is surrounded by the same electrostatic control gate (110) or by an electrostatic control gate (110) different from that one surrounding the other areas (122) of the semiconductor layer (120).

5. The memory device (100) according to any of the preceding claims, wherein the selection transistor further includes one or more dielectric portion(s) (126) each arranged between two first areas (122) of the semiconductor layer (120) and such that each of the dielectric portions (126) is surrounded by the first areas (122) of the semiconductor layer (120).

6. The memory device (100) according to any of the preceding claims, wherein the selection transistor further includes inner dielectric spacers (115) arranged against sidewalls of one or more parts (108) of the electrostatic control gate (110).

7. The memory device (100) according to any of the preceding claims, wherein the memory stack (158) includes a ferroelectric material layer or an oxide layer or an ionic layer.

8. A microelectronic component (1000) including several memory devices (100) according to any of the preceding claims, and wherein:
- the electrostatic control gates (110) of the selection transistors of several memory devices (100) are common and formed by the same material portions, and/or
- one of the contact regions (116, 118) is common to two selection transistors of neighbouring memory devices (100).

9. A method for making a memory device (100) comprising at least one memory stack (158) electrically connected in series with a selection transistor, comprising:
a) making, over a substrate (102), at least one alternating stack (134) of portions of a first material (136) and of portions of a second material (138), the first and second materials being able to be selectively etched with respect to each other, then
b) making a temporary gate (142) covering a part of an upper face and of lateral faces of the stack (134), then
c) making dielectric spacers (114) against sidewalls of the temporary gate (142), then
d) etching parts of the stack (134) that are not covered with the temporary gate (142) and the dielectric spacers (114), then
e) etching the temporary gate (142), then
f) etching the portions of the first material (136) selectively with respect to the portions of the second material (138), then
g) making at least one part of an electrostatic control gate (110) of the selection transistor in a space formed by etching of the temporary gate (142), such that the dielectric spacers (114) are arranged against the sidewalls of the electrostatic control gate (110), then
h) etching the portions of the second material (138), then
i) making a semiconductor layer (120) comprising several first areas (122) configured to form an electrical conduction channel of the selection transistor and arranged against the gate (110) in locations formed by etching of the portions of the second material (138), the semiconductor layer (120) extending, with no discontinuity with the first areas (122), while forming second areas (124) covering at least part of the sidewalls of the dielectric spacers (114) and which are not arranged directly against the electrostatic control gate (110), then
j) making, over the substrate (102), contact regions (116, 118) electrically coupled to the first areas (122) of the semiconductor layer (120) via the second areas (124) of the semiconductor layer (120), each second area (124) of the semiconductor layer (120) extending between the contact regions (116, 118) and the dielectric spacers (114), the contact regions (116, 118) forming source/drain regions of the selection transistor, one of the contact regions (118) including the memory stack (158) interposed between a first conductive portion (157), electrically connecting the memory stack (158) to the semiconductor layer (120), and a second conductive portion (156) forming an electrical contact of the memory stack (158), wherein the method further include making a gate dielectric layer of the selection transistor such that parts of the gate dielectric layer are each arranged between a part of the electrostatic control gate and one of the first areas of the semiconductor layer.

10. The method according to claim 9, further including, between steps d) and e), depositing an insulating dielectric material (128) around the dielectric spacers (114), then etching cavities (150) in the insulating dielectric material (128) such that each of the cavities (150) comprises at least one lateral wall formed by one of the dielectric spacers (114), and wherein:
- step i) is implemented such that the second areas (124) of the semiconductor layer (120) cover at least part of the lateral walls of the cavities (150), and
- step j) is implemented such that each of the contact regions (116, 118) is arranged in one of the cavities (150).

11. The method according to any of the claims 9 or 10, including a step of depositing the gate dielectric layer (112) of the selection transistor implemented:
- between steps f) and g), in the space formed by etching of the temporary gate (142), the electrostatic control gate (110) of the selection transistor being in this case made over the gate dielectric layer (112), and/or
- between steps h) and i), in the locations formed by etching of the portions of the second material (138), the semiconductor layer (120) being made afterwards by covering the gate dielectric layer (112).

12. The method according to any of the claims 9 to 11, wherein step i) is implemented such that the first areas (122) of the semiconductor layer (120) cover walls of the locations formed by etching of the portions of the second material (138), and the method further includes, between steps i) and j), making dielectric portions (126) in remaining spaces of the locations and such that each of the dielectric portions (126) is surrounded by the first areas (122) of the semiconductor layer (120).

13. The method according to any of the claims 9 to 11, wherein step i) is implemented such that the first areas (122) of the semiconductor layer (120) filling the locations formed by etching of the portions of the second material (138).

14. The method according to any of the claims 9 to 13, further including, between steps d) and e), etching parts of the portions of the first material (136) arranged directly above the dielectric spacers (114), and making inner dielectric spacers (115) instead of the etched parts of the portions of the first material (136).
